# EUROPEAN PATENT SPECIFICATION

(11) **EP 0 563 009 B1**
(45) Date of publication and mention of the grant of the patent: **13.05.1998**
(21) Application number: 93810183.9
(22) Date of filing: 15.03.1993
(51) Int. Cl.: H05B 33/26, H05B 33/10

(54) **Organic electroluminescent element**
Organisches Elektrolumineszentelement
Elément électroluminescent organique

(30) Priority: 23.03.1992 EP 92810210
(43) Date of publication of application: 29.09.1993
(73) Proprietor: Ciba Specialty Chemicals Holding Inc., 4057 Basel (CH)
(72) Inventor: Ohtani, Junji, Kobe-shi, Hyogo (JP); Matsumura, Michio, Dr., Kobe-shi, Hyogo (JP); Ikuta, Katsura, Kobe-shi, Hyogo (JP); Deno, Takashi, Takarazuka-shi, Hyogo (JP)

(56) References cited:
- EP-A- 0 468 438
- EP-A- 0 468 440

## Description

The invention relates to an electroluminescent element industrially useful for display devices.

Recently, an electroluminescent element (referred to as "EL element" hereinafter) has been noticed for the application as a luminescent device in various display equipments, as it is high in visual cognition for its self luminescence and excellent in shock resistance for its perfect solid nature.

EL elements are classified into inorganic ones using inorganic compounds for emitter material and organic ones using organic compounds for light-emitting material. Among them, applied voltage can be largely lowered for the organic EL elements and researches for their commercialization are actively under way.

The principle of the organic EL elements is based on the phenomena that electrons and positive holes, injected from a negative electrode and a positive electrode respectively, recombine each other in the organic light-emitting layer, thereby generating excitons, which are excited states of the emitter material. The thus generated excitons diffuse in said light-emitting layer, which then emit light when it is deexcited to its ground state. Therefore, the wavelength of emitted light is only dependent on the difference in energy between the ground state and the excited states.

As is obvious from the above principle, it is not necessary to apply an AC voltage to organic EL elements, and moreover, it is possible to obtain light of any desired color since there exist innumerable organic compounds, from which a suitable light-emitting material can be selected.

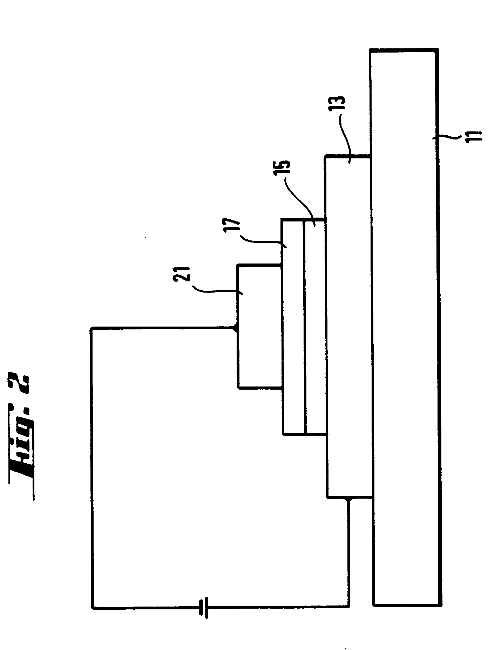

The constitution of said organic EL elements is basically (1) an anode/a light-emitting layer/a cathode, (monolayer type). Constitutions in which a hole transport layer or an electron transport layer is provided appropriately are also known, for example, a consti tution of (2) an anode/a hole transport layer/a light-emitting layer/a cathode (see Fig. 2), (3) an anode/a light-emitting layer/an electron transfer layer/a cathode and that of (4) an anode/a hole transport layer/a light-emitting layer/an electron transfer layer/a cathode (multilayer types).

As the material for the light-emitting layer used in the element (1), it is required that it has a strong fluorescence by itself and has high abilities of transporting both hole and electron and further has an ability of receiving them from both electrodes efficiently. However, no substance satisfying these functions has been known and even a substance barely satisfying the conditions gives an element of very unsatisfactory performance.

While an electron transfer layer is required in the element of types (3) and (4), organic compounds having electron transport ability to be used in the layer are generally unstable. When an organic EL element is prepared by using them, the life of the element is very short.

On the other hand, in the element of type (2), organic compounds stable and high in hole transport activity have been widely known in the fields including electrophotographic photosensitive materials. Studies on the preparation of organic EL elements have been widely made by using them. Conventionally, many efforts had been made especially for seeking a new light-emitting material (for example, Japan Patent Laid-open No. 245087/1989) and further for an optimization between the light-emitting materials and the hole transport materials or for seeking a new hole transport materials suitable to organic EL elements (for example, Japan Patent Laid-open No. 54288/1991). However, many of them are restricted in the use due to their low luminescence and short life.

As a recent example, Takeuchi et al tried to increase the luminance of aluminoquinoline (AlQ₃) by using an amorphous hole transport layer and by doping to the light-emitting layer [Polymer Preprint, Japan Vol. 40, Nos. 5-11, E961 (1991)]. It is known, however, that luminance can be increased by means of doping [C.W. Tang et al., J. Appl. Phys., 65 (1989) 3610-3616]. The study by Takeuchi is in principle the same as Tang's in view of the improvement in the emitting layer.

Minato et al studied on the work function of cathode materials, especially its influence upon the injection efficiency of electrons from the cathode to the light-emitting layer thereby using a metal of low work function as the cathode, AlQ₃ as the light-emitting material and tetra-aryl diamine as the hole transport layer [Polymer Preprint, Japan, Vol. 40, Nos. 5-11, E963 (1991)]. Minato adopted the two methods to increase the luminance. One of the method is to fabricate the cathode by using an alloy of two kinds of metals having low work function by covapor deposition. The second method by Minato adopts the cathode comprising an alloy of Mg having low work function and Ag of high work function (C.W. Tang et al., Appl. Phys. Lett., 51 (1987) 913-915). This method adopts codeposition of Mg and Ag, and follows the study of C.W. Tang et al in 1987. While Minato et al concluded that lower work function gives higher injection efficiency of electrons and higher quantum yield of light emission, they failed to obtain satisfactory results by using other metal species than Li alloy according to the corresponding Japanese preprints [Polymer Preprints, Japan, Japanese edition, Vol 40, No. 10, 3582 (1991)].

Imai et al obtained a luminance of a few ten thousands cd/m² according to Polymer Preprints, Japan Vol 40, Nos. 5-11, E-969 (1991) in a similar manner to Takeuchi et al as mentioned above. The quantum yields shown by Takeuchi [Polymer Preprints, Japan, Japanese edition Vol 40, No. 10, 3602 (1991)] is the same value as Tang's (C.W. Tang et al., J. Appl. Phs., 65 (1989) 3610-3616), and no improvement is given.

An object of the present invention is to provide an EL element which can give a higher luminance than those proposed conventionally with a low applied voltage of an anode/a hole transport layer/a light-emitting layer/a cathode, and, with no restriction of material used.

Another object of the present invention is to provide an EL element of longer life than the conventional EL elements.

Fig. 1 (a) to Fig. 1 (c) show conceptionally examples of the layer structure of the organic EL element of the present invention.

Fig. 2 shows conceptionally an example of the layer structure of a conventional organic EL element.

Fig. 3 shows an illustration of a vacuum coater which may be used for producing the EL element of the present invention.

Fig. 4 is a graph illustrating luminance-bias voltage characteristics of the element of the present invention as compared with a comparative example.

Fig. 5 is a graph illustrating the decay of the EL intensity with the lapse of time.

Fig. 6 is a photograph showing the discontinuous membrane structure of Au obtained in Example 16.

The present invention is an organic electroluminescent element (1) in which an anode (13), a hole transport layer (15), a light-emitting layer (17) and a cathode (19) are laminated in this order, characterized in that said cathode comprises a metal block portion or portions comprising a metal having a high work function (work function > 4.2 → hereinafter referred to as "Metal A") and a metal block portion or portions comprising a metal having a lower work function than Metal A (→ hereinafter referred to as "Metal B"), both of the metal block portions of Metal A and Metal B being in contact with the surface of the light-emitting layer (17) and the difference between the work functions of Metal A and Metal B being ≥ 0.4.

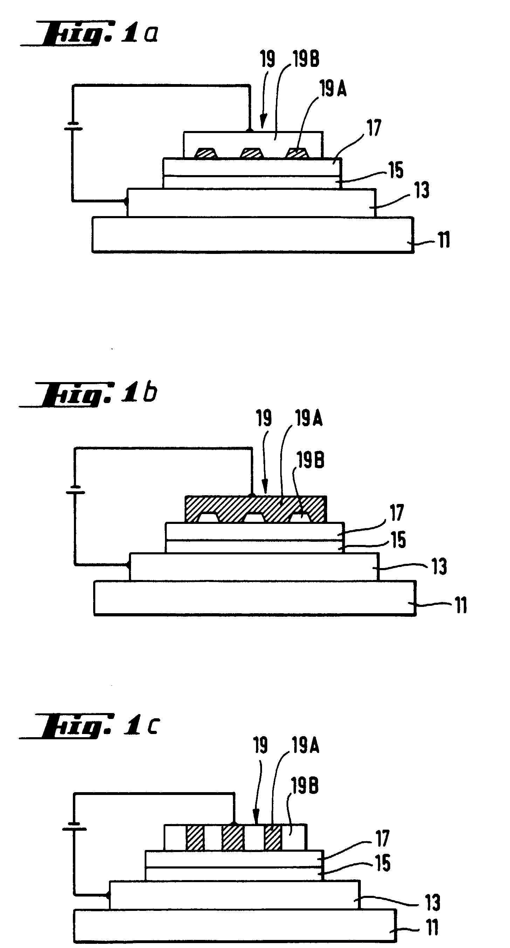

The manner of providing the metal block portions of Metal A and Metal B is not limited to that shown in Fig. 1 (a), as long as the light-emitting layer is in contact with both of the metal block portions of Metal A and those of Metal B, and may include also the manner of the cases as shown in Fig. 1 (b) and Fig. 1 (c).

Here, the term "metal block portion" means that atoms of a metal are aggregated to form a block or blocks of the metal, as conceptionally shown in Figure 1 (a) to Fig. 1 (c). These means atoms of Metal A and Metal B do not form an alloy such as a solid solution, an eutectic mixture, an intermetallic compound or a combination thereof as usually formed when Metal A and Metal B are co-deposited by vacuum deposition, i.e., when Metal A and Metal B are vapordeposited simultaneously onto a substrate. It should be noted here that such an alloy possesses a work function which is different from any work function of each metal constituting the alloy.

In the present invention, each of the metal block portions of Metal A and of Metal B maintains the inherent work function of Metal A or B.

The metal block portion or portions of Metal A and Metal B are formed on the surface of the light-emitting layer by any chemical, physical or physico-chemical method known to the art. For instance, techniques of vapor-deposition to form a thin film, etching of the film and further deposition of the second metal may be applied for the desired purpose.

The cluster beam deposition method may be applied for the purpose of forming the metal block portion or portions according to the present invention.

Also, painting or printing technique may be used to form metal block portions on the light-emitting layer.

In order to obtain the desired structure of the block portions of Metal A and Metal B, it is most preferred to form a discontinuous membrane of Metal A by vapordepositing Metal A while observing the formation progress and the structure of the membrane being formed, followed by further deposition of Metal B onto the discontinuous membrane of Metal A. It is well-known to the art that, at the initial stage of the membrane formation by vapor deposition, many metals form a discontinuous membrane. So, the membrane thickness of Metal A may be a good measure to determine whether the desired discontinuous membrane of Metal A can be obtained or not. However, in cases where the vapor deposition of Metal A is to be attained under reduced pressure (in vacuo), it is generally difficult to predict the state of the deposition of Metal A, because the manner of deposition, in particular, the manner of discontinuous membrane deposition depends strongly on the kind of metals to be deposited, the combination of a metal with the light-emitting layer, the temperature of the substrate, the deposition rate and so on.

In a preferred embodiment to form the cathode according to the present invention, the cathode is formed by vapordepositing Metal A onto the surface of the light-emitting layer to form an extremely thin membrane, the thickness of which is preferably in the range of 2·10⁻¹⁰ m to 2·10⁻⁸ m (2 Å to 200 Å), more preferably in the range of 5·10⁻¹⁰ m to 1.5·10⁻⁸ m (5 Å to 150 Å), further more preferably in the range of 5·10⁻¹⁰ m to 1·10⁻⁸ m (5 Å to 100 Å) and which does not form a uniform integrated membrane but form a broken, discontinuous membrane or islands-like pattem of Metal A on the light-emitting layer, and by vapordepositing further Metal B to fill with Metal B the broken part or parts between the islands of Metal A, bringing the portion or portions of Metal B into contact with the surface of the emitting layer.

Be noted here that the thickness of the islands pattem of Metal A is different depending upon the kind of Metal A to be deposited.

The thickness of the layer of Metal B is not critical as long as it possesses electroconductivity, but it would be sufficient if the thickness is at least 5·10⁻⁸ m (500 Å).

Although the cathode as shown in Fig. 1 (a) may be formed as explained and described above, the cathode as shown in Fig. 1 (b) may be formed preferably by first depositing Metal B to form a discontinuous membrane of Metal B followed by formation of the film of Metal A, according to the same manner as in the above case shown in Fig. 1 (a) except that Metal A and Metal B in Fig. 1 (a) are transposed with each other.

The ratio of the contact area of Metal A with the light-emitting layer relative to the contact area of Metal B is not particularly critical. However, the percentage of the former relative to the latter may preferably be 2 to 98%, more preferably 5 to 97%, most preferably 7 to 95%, while it depends on the kinds of metals to be deposited, combination of Metal A and Metal B, and so on.

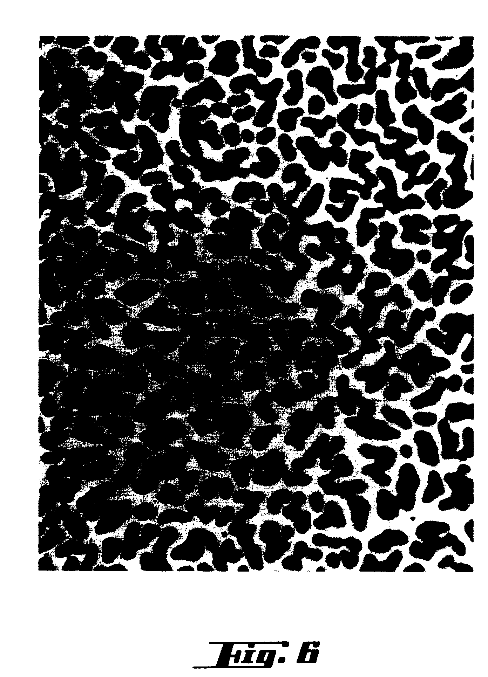

In cases where Au is used as Metal A, the relationship between the membrane thickness of Au and the percentage of the area of Au relative to the light-emitting layer is determined based on the result of observation with an electron microscope (e.g., see Fig. 6), and the results are shown in the following table.

| membrane thickness of Au(10⁻¹⁰ m = Å) | percentage of the area of Au (%) |
|---|---|
| 5 | 27.2 |
| 20 | 61.7 |
| 50 | 93.6 |
| 80 | 96.7 |

The term "work function" means the value (φ) obtained by the Photoelectron Emission Method as described, for example, in Kagaku Binran 3rd edition (by The Chem. Society of Japan) and CRC Handbook of Chemistry and Physics.

The term "high work function" for Metal A means a value (φ_{A}) above 4.2 eV, and the term "low work function" for Metal B means the value (φ_{B}) may preferably be not greater than 4.2 eV. Further, in the present invention, Metal A and Metal B should be selected such that the difference between φ_{A} and φ_{B}, i.e., φ_{A}-φ_{B} is at least 0.4eV, preferably between 0.4 and 2.5 eV, more preferably between 0.5 eV and 2.0 eV. In other expressions, the preferably range is 2.5 eV≥φ_{A}-φ_{B}≥0.4 eV, and the more preferably range is 2.0 eV≥φ_{A}-φ_{B}≥0.5 eV. So, as long as the difference φ_{A}-φ_{B} is at least 0.4 eV, Metal A and Metal B may be selected from those having any work function. So, Al (aluminium) having a work function of 4.28 may be employed as Metal A or Metal B depending upon the metal to be combined with Al, Al (φ=4,28 eV) can be used as Metal A when Mg (φ=3.66) is employed as Metal B. And Al may be used as Metal B when Au (φ=5.1) is employed as Metal A.

The following Table lists up Metal A and Metal B to be employed in the present invention.

| Metal A of high work function (φ_{A}) | Metal B of low work function (φ_{B}) | Combination of Metals A and B (φ_{A}-φ_{B}) |
|---|---|---|
| Au (5.1) | Al (4.28) | Au-Mg (1.44) |
| Ag (4.26) | Mg (3.66) | Ag-Mg (0.60) |
| Cu (4.65) | In (4.09) | Cu-Mg (0.99) |
| Al (4.28) | Mn (4.1) | Al-Mg (0.62) |
| Pd (5.55) | | Pd-Mg (1.89) |
| Pt (5.64) | | Pt-Mg (1.98) |
| Ni (5.15) | | Au-Al (0.82) |
| | | Au-In (1.01) |
| | | Ni-Mg (1.49) |

As the metal having a high work function, there may be preferably mentioned Ni, Au, Pt, Pd, Ag, Cu and alloys thereof. More preferably are mentioned Pt, Pd, Ni and Au.

As the metal having a low work function, there may be preferably mentioned Li, Na, K, Al, Mg, Mn, In and alloys thereof. More preferable ones are Li, In, Al and Mg and alloys thereof.

As each hole and light-emitting layers, it is preferred to use a material which conducts selectively the hole or the electron and is as uniform as possible when made into a thin membrane and contains substantially no pinhole. The hole or the electron injected from the anode (13) or the cathode (19) is recombined in the light-emitting layer (17) to give luminescence.

Any known material can be used as the hole transport layer (15). For example, those usable include, triazol derivatives, oxadiazol derivatives, imidazol derivatives, pyrazoline derivatives, pyrazolone derivatives, hydrazone derivatives, stilbene derivatives, tertiary aromatic amine compounds, styryl amine compounds, various phthalocyanines of metals and nonmetals as well as their derivatives (see for example Japanese Laid-open Pat. Publn. No. 54288/1991).

The membrane thickness of the hole transport layer (15) and the light-emitting layer is preferably each in the range of 10⁻⁹ m to 2·10⁻⁵ m (10 to 2 Å). A membrane thickness less than 10⁻⁹ m (10 Å) tends to leak the hole and the electron respectively to the cathode (19) and the anode (13) and is feared that it gives no luminescence. A membrane thickness more than 2·10⁻⁵ m (200000 Å) prevents arrival of the hole and the electron to the recombining region to cause no luminescence.

Any known material can be used as the light-emitting layer (17) (see for example Japanese Laid-open Pat. Publn. No. 256584/1989). There is no restriction if it has a high fluorescence and susceptible to injection of holes and electrons in a state of solid thin membrane condition and it can form a uniform thin membrane and said thin membrane is stable for a long period.

The hole transport layer (15) and the light-emitting layer (17) can be constituted of a plural of components at least two respectively. For this purpose, the methods include, for example, a co-deposition of the materials used in each layers and an application of a mixture of each materials as the depositing source. Although crystallization of each organic layers has been mentioned to be a cause of deterioration of the organic EL element, crystallization of each components can be prevented and the life can be prolonged by using the above-mentioned method.

As a material for the anode (13), there may be used any known material which can attain the purpose of the present invention. However, a conductive material having a high work function is used for the anode (13) to improve the hole injection efficiency into the hole transport layer (15). It is also preferred that the anode (13) layer has a high transmittance in the wave length region of the luminescence to bring out efficiently the luminescence irradiated from the light-emitting layer (17). Typically, a thin film of nickel, platinum, palladium and their alloys, ITO (indium tin oxide) and SnO₂ (stannic oxide) may preferably be employed. In the case of an anode material originally opaque in the visible ray region such as nickel and gold, it is essential that the film thickness is made to be ca. 10⁻⁹ m to 2·10⁻⁸ m (10 to 200 Å) to assure the transmittance.

Some materials may cause deterioration of the characteristics due to a dradual oxidation and moisture absorption when stood in air. Hence, a protective layer may be provided if required or the whole element may be included in a cell and the cell may be filled with silicone oil.

A further object of the invention is a process of the preparation of an organic electro luminescent element comprised of an anode, a hole transport layer, a light-emitting layer and a cathode layer laminated in this order, characterized in that the cathode layer is formed on the light-emitting layer by firstly depositing by vacuum deposition a metal having a high work function to such a membrane thickness to form a discontinuous mem brane of the metal having a high work function and subsequently depositing by vacuum deposition a metal having a low work function on the metal having a high work function, whereby both of the deposited metal having a high work function and the deposited metal having a low work function are brought into contact with the light-emitting layer. Another object of the invention is a process of the preparation of an organic electroluminescent element comprised of an anode, a hole transport layer, a light-emitting layer and a cathode layer laminated in this order, characterized in that the cathode layer is formed on the light-emitting layer by firstly depositing by vacuum deposition a metal having a low work function to such a membrane thickness to form a discontinuous membrane of the metal having a low work function and subsequently depositing by vacuum deposition a metal having a high work function on the metal having a low work function, whereby both of the deposited metal having a high work function and the deposited metal having a low work function are brought into contact with the light-emitting layer.

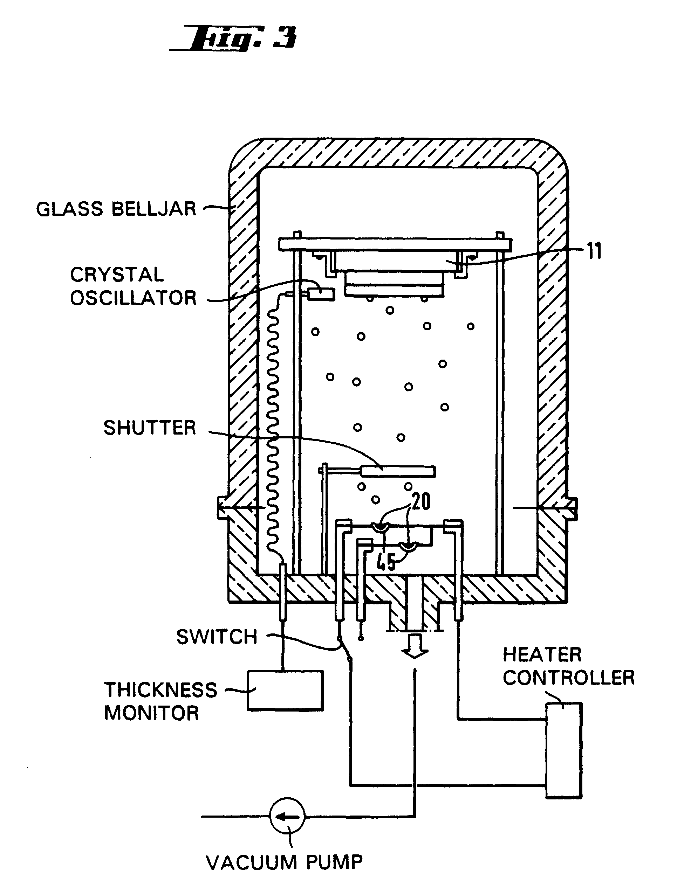

The organic thin membrane EL element according to the present invention is prepared by laminating each layers described above on the surface of a substrate (11). The membrane can be formed by casting method and Langmuir - Blodgett's method (LB method) and others. However, especially preferred is vacuum deposition. Fig. 3 shows a schematic illustration of such a vacuum coater. For the deposition of an anode on the substrate, the material for the anode is heated to a temperature higher than its melting point and evaporated by electron beam heating in the case a high-melting material such as ITO is used and by resistance heating in the case a relatively low-melting material such as gold is used. The vacuum during deposition is preferably 133 Pa (1·10⁻³ Torr) or less, more preferably 1.33 Pa (1·10⁻⁵ Torr) or less. The distance between the deposition source (20) and the substrate (11) is preferably not less than 15 cm. To prepare a uniform dense membrane when the hole transport layer, the light-emitting layer and the cathode are successively deposited, it is required to control precisely the deposition source boat temperature, the depositing rate and the substrate temperature in accordance with the material used.

In the case of forming the organic layers of said EL element by casting method, the emitting-layer comprises at least one light-emitting material and optionally contains hole transport material, electron transport material and resinous binder. The hole transport layer comprises at least one hole transport material and optionally contains a resinous binder. The electron transport layer comprises at least one electron transport material and optionally contains a resinous binder. The casting method is for example described in Japan Patent Laid open No. 2096/1992.

As the resinous binder, polycarbonate (bisphenol A, S or Z type), polyester, polyethylene, polystyrene, polyvinylcarbazole, polyvinylbutyral, polyallylate, polyvinylalcohol, polyacrylonitrile, polyacrylamido, polyamido, vinylchloride, vinylacetate, vinylidene chloride, methacryl resin, acryl resin, phenol resin, epoxy resin, alkyd resin, silicone resin and phenoxy resin can be exemplified. Single compound or a mixture containing two or more of the compounds mentioned above are used as the binder.

In the case of laminate type, the binder used in the lower layer must have chemical resistance to prevent dissolution to the upper layer at coating thereof. For such purpose, use of silicon resins having good chemical resistance is recommended. Polyfunctional monomers can become chemical resistant by curing it in the form of a three dimensional structure after coating.

As a method for forming films of each organic layer, Immersion coating, Spin cast coating, Spray coating and Bar coating can be referred to.

Preferred thickness of the films in the formation of layers and EL element (by the casting method) are as follows.

In the case of the monolayer type (1), the preferred thickness of the film of the light-emitting light is 0.02-5µm. The film thickness of 0.01-2µm is preferred for each organic layer of the multilayer types (2) - (4), and thickness of no more than 5µm is preferred for whole organic layers.

The applied voltage for the luminescence of the EL element is generally in the range of 4 volts to 30 volts and preferably 4 volts to 20 volts in the present invention to maintain the life.

### Example 1:

On an ITO glass substrate (made by Matsuzaki Shinku Co., ITO film thickness 2·10⁻⁷ m (2000 Å), sheet resistance 10 Ω/cm²), Compound (I) represented by the following formula is deposited as a hole transport substance by vacuum deposition under a vacuum of 0.8 Pa (6.0·10⁻⁶Torr) and at a depositing rate of 0.8 Å/sec to a membrane thickness of 5·10⁻⁸ m (500 Å) to form a hole transport layer (15).

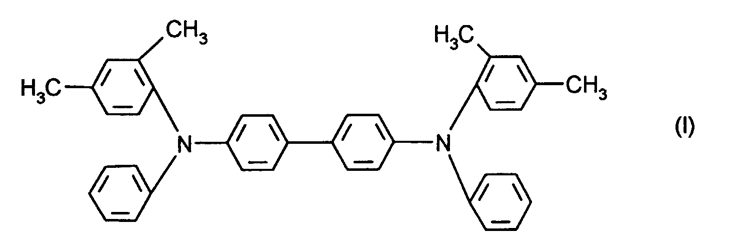

Then, on the hole transport layer (15) thus prepared, Compound (1) represented by the following formula is deposited as a light-emitting material under a depositing condition of of 0.8 Pa (6.0x10⁻⁶ Torr) and 8·10⁻¹¹ m/s (0.8 Å/sec) to a membrane thickness of 5·10⁻⁸ m/s (500 Å) to form a light-emitting layer (17).

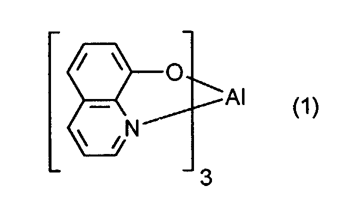

Then, on the light-emitting layer (17), gold as a cathode layer A (19) is deposited under a vacuum of of 0.67 Pa (5.0·10⁻⁶ Torr) and a depositing rate of 10⁻¹¹ m/s (0.1 Å/sec) to a film thickness of 5·10⁻¹⁰ m (5 Å). Then, magnesium as a cathode layer B (19B) is deposited on it to a film thickness of 2·10⁻⁷ m (2000 Å).

By using the ITO side as the anode (13) and the magnesium side as the cathode (19), a bias of 10 V is applied to the above element. A luminescence showing a luminance of 1620 cd/m² is confirmed as the average value of five elements. For determination of luminance, Luminometer LS-110 manufactured by Minolta Camera Co. Ltd. is used.

### Examples 2 to 11:

The hole transport substances, the light-emitting substances and the cathode film thicknesses and others are shown in Table 1. Other experimental conditions are made to be the same as in Example 1. The organic materials used for the experiments are as follows:

### <Hole transport material>

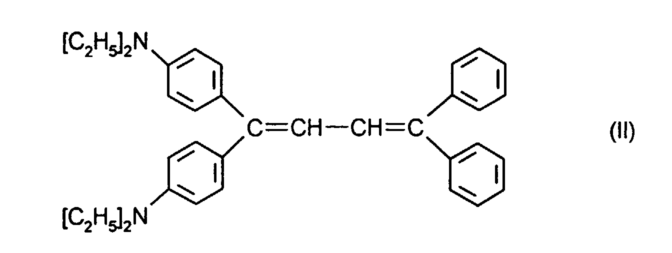

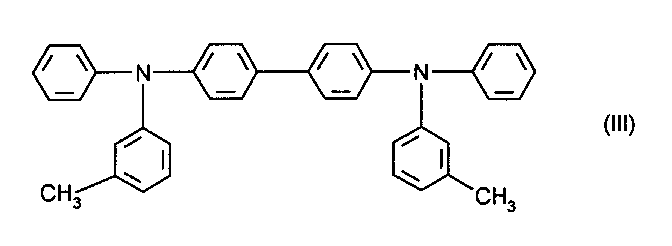

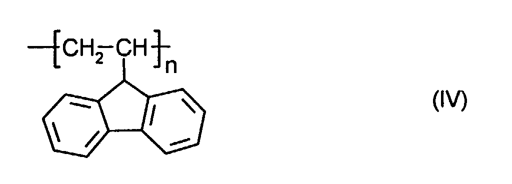

### <Light-emitting material>

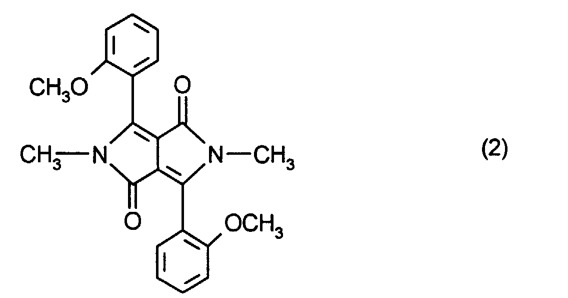

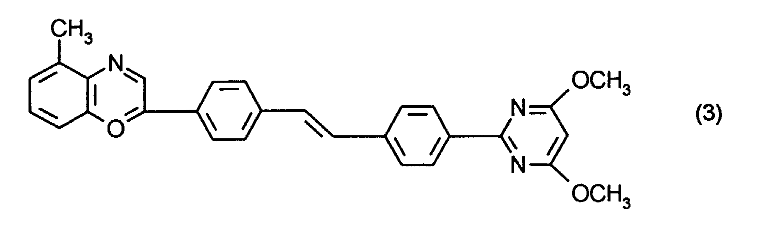

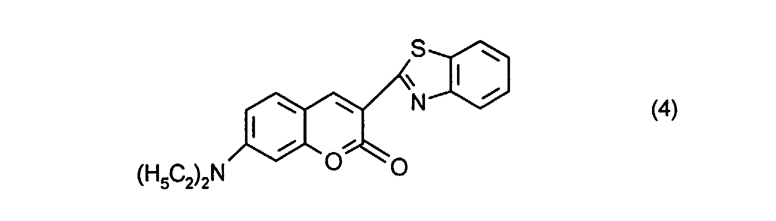

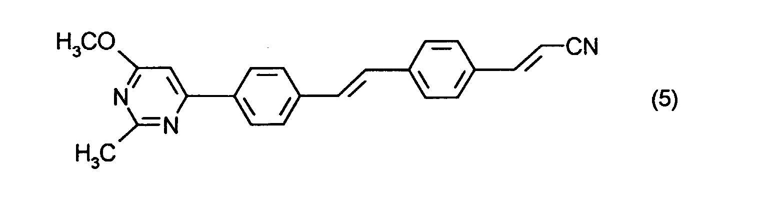

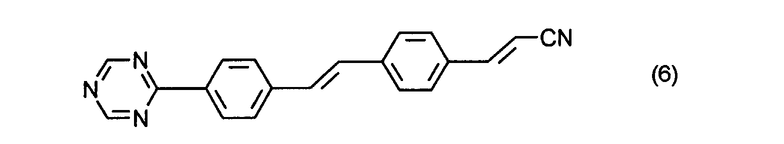

### <Electron transfer layer material>

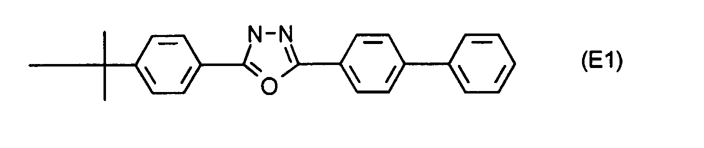

**Table 1**

| The figures in ( ) show membrane thickness (10⁻¹⁰ m = Å) | | | | | |
|---|---|---|---|---|---|
| Example | Material for the hole transport layer | Material for the light-emitting layer | Cathode layer A | Cathode layer B | Luminance (when 10 V is applied) (cd/m²) |
| 1 | I (500) | 1 (500) | Au (5) | Mg (2000) | 1620 |
| 2 | I (500) | 1 (500) | Au (150) | Mg (2000) | 1440 |
| 3 | 1 (500) | 1 (500) | Au (20) | Mg (2000) | 2978 |
| 4 | I (500) | 1 (500) | Ag (20) | Mg (2000) | 1725 |
| 5 | I (500) | 1 (500) | Cu (20) | Mg (2000) | 1382 |
| 6 | I (500) | 1 (500) | Al (20) | Mg (2000) | 1330 |
| 7 | I (500) | 1 (500) | Pd (20) | Mg (2000) | 3677 |
| 8 | I (500) | 1 (500) | Pt (20)* | Mg (2000) | 3868 |
| 9 | I (750) | 2 (1000) | Au (20) | Mg (2000) | 883 |
| 10 | II (500) | 1 (500) | Au (20) | Al (2000) | 2752 |
| 11 | III (500) | 3 (500) | Au (20) | In (5000) | 926 |

| | | | | | |
|---|---|---|---|---|---|
| * By electron beam deposition | | | | | |

### Example 12:

When a voltage of 12 V is applied to the element prepared by Example 3, a luminescence showing a luminance of 11,300 cd/m² is confirmed.

### Example 13:

The element is prepared in the same manner as in Example 3 except that Ni is used in replacement of Au. When a bias voltage 10 V is applied to the element, a luminescence showing a luminance of 1756 cd/m² as the average value of five elements is confirmed.

### Comparative Examples 1 to 5:

Elements are prepared in completely the same manner as in Example 1 except that the cathode layer A is not provided. The results as shown in Table 2 are obtained by the constitutions shown in the Table.

**Table 2**

| The figures in ( ) show membrane thicknesses (10⁻¹⁰ m = Å) | | | | | |
|---|---|---|---|---|---|
| Comparative Example against Examples 1 to 11 | | Material for the hole transport layer | Material for the light-emitting layer | Cathode | Luminance (when 10V is applied) (cd/m²) |
| 1 | (to Ex. 1-8) | I (500) | 1 (500) | Mg (2000) | 1104 |
| 2 | (to Ex. 9) | II (750) | 1 (1000) | Mg (2000) | 527 |
| 3 | (to Ex. 10) | II (500) | 1 (500) | Al (2000) | 1262 |
| 4 | (to Ex. 11) | III (500) | 3 (500) | In (5000) | 599 |
| 5 | An example of | I (500) | 1 (500) | Mg:Ag * | 1212 |
| | using alloy in | | | 10:1 | |
| | Comparative Ex. 1 | | (2000) | | |

| | | | | | |
|---|---|---|---|---|---|
| * An alloy by codeposition | | | | | |

### Comparative Example 6:

A voltage of 12 V is applied to the element prepared by Comparative Example 1. A luminance of 2100 cd/cm² is attained.

As obvious from the investigation of the results of Examples and Comparative Examples, a high luminance can be attained by preparing a cathode by laminating a cathode layer A comprising a metal having a high work funciton and a cathode layer B comprising a metal having a low work function on a light-emitting layer in this order. It means that from the viewpoint of the same luminance, the element can be actuated at a lower voltage than the conventional examples and thus heat evolution is prevented to prolong the life or longevity of the element.

### Example 14 and Comparative Example 7:

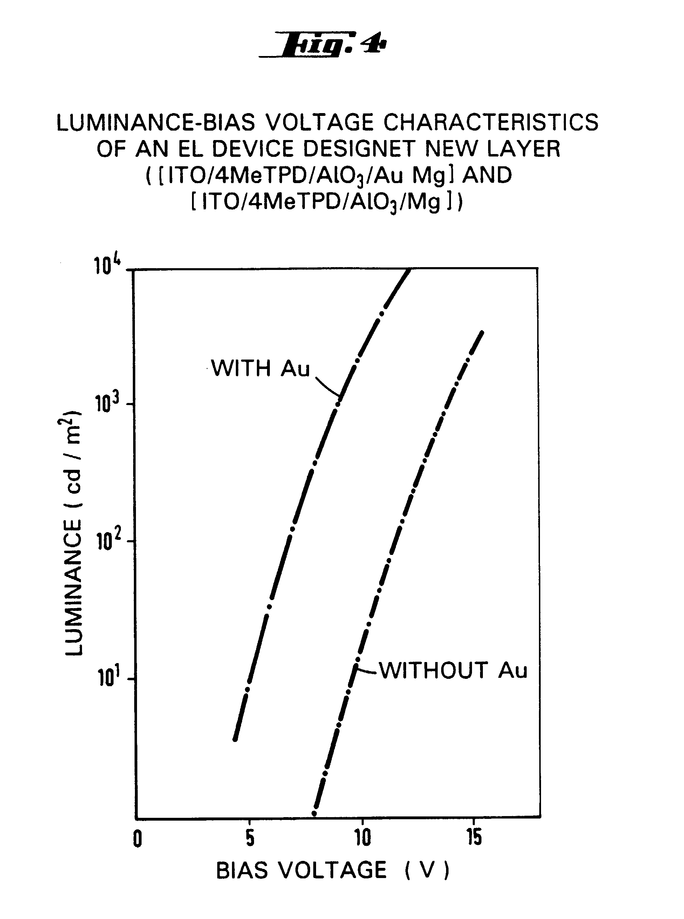

With respect to elements which are the same as in Example 3 except that the membrane thickness of the positive hole transport layer and the light-emitting layer are made to be 2.5·10⁻⁸ m (250 Å), respectively, the effect of Au block portions (Au membrane thickness being 2·10⁻⁹ m = 20 Å) is investigated. The relationships of the applied bias voltage (V) and the luminance (cd/m²) for respective elements are illustrated in Fig. 4, from which it can be understood that the electroluminescent element according to the present invention shows higher luminance and can be operated under lower bias voltage.

### Example 15 and Comparative Example 8:

To the same elements as prepared in Example 3 and Comparative Example 1, respec tively, there is applied a constant electric current of 50 mA/cm² and luminance is determined every ten minutes by using Luminometer LS-110 manufactured by Minolta Camera Co., Ltd.

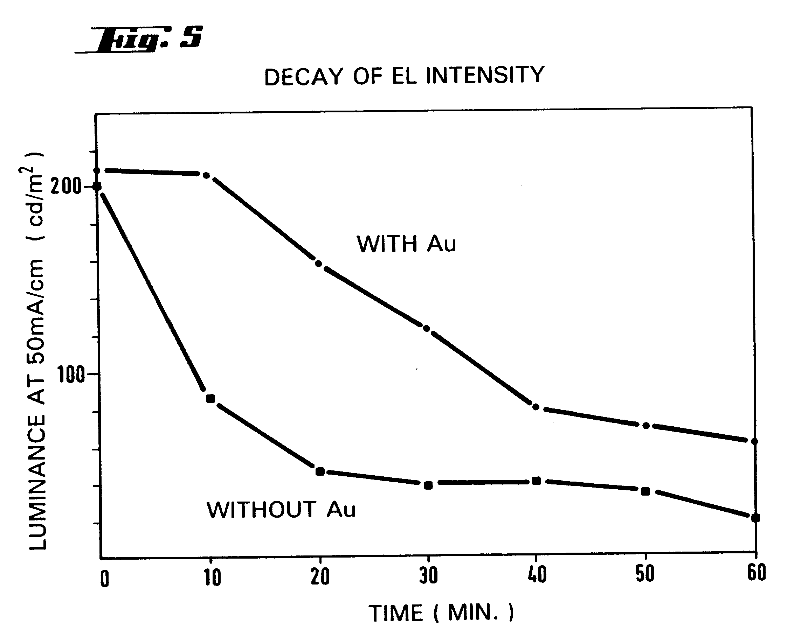

The results are illustrated in Fig. 5, from which it can be understood that the element according to the present invention can maintain higher luminance for longer period of time as compared with the comparative element.

### Example 16:

Onto an ITO glass substrate, there are vapor-deposited the positive hole transport compound (I) to a membrane thickness of 2.5·10⁻⁸ m (250 Å), subsequently light-emitting material (1) to a membrane thickness of 250 Å followed by vapor-deposition of gold (Au) to a membrane thickness of 2.10⁻⁹ m (20 Å). In order to investigate the state of the thus deposited Au, the following experiment is carried out. Namely, onto the surface of the sample carrying the thus deposited Au, there is further vapor-deposited carbon under a reduced pressure of around of 1.7 Pa (1.3·10⁻⁵ Torr) to a membrane thickness of around 2.10⁻⁸ m (200 Å). The sample carrying the resulting vapor-deposited film is immersed gently in acetone to dissolve the organic substance carried by the carbon. Then, the sample is transferred to a vat containing distilled water. The film which peales off and floated is scooped up on a commercially available copper mesh (150 mesh) for the use of observation with an electron microscope, and is observed by using a transmission type electron microscope (manufactured by JEOL Ltd., Japan; model: JEM-2000FX), under an accelerating voltage of 100 kV, with a direct magnification of 3x10⁵. As the result, the discontinuous Au deposition as shown in Fig. 6 is confirmed (see Fig. 6). This means that, when Metal B such as Mg having a low work function is vapor-deposited on the discontinuous gold membrane, both of the Au and the Mg will come into contact with the surface of the light-emitting layer.

In this specification, the thickness of the discontinuous membrane, which is formed by the vapor-deposition technique such as vapor-depositon in vacuo and electron beam vapor deposition, is determined by measuring the change of the resonance frequency of a crystal oscillator provided inside a vacuum coater (see Fig. 3) accompanying the formation of the membrane followed by calculation using the density and the acoustic impedance ratio of the membrane.

Further, the thickness of the organic layer and the negative electrode layer B, which are formed by the vapor-deposition technique, are determined in the same manner as in the discontinuous membrane.

The effect of the present invention is further explained in more detail by comparing a monolayer type EL element comprising cathode A and Cathode B and a monolayer type EL element comprising cathode B only wherein the monolayer type EL element was formed by Spin cast coating.

### Example 17:

A composition for a light-emitting layer was obtained by sufficiently mixing 2.00x10⁶ mol of the above mentioned light-emitting material (4), 1.28x10⁻⁴ mol of the above mentioned hole transport material (IV) and 7.00x10⁻⁵ mol of the above mentioned electron transport material (El) added to 3.00 mol of toluene.

### Preparation of EL element:

On a ITO grass substrate (made by Matsuzaki Shinku Co., ITO film thickness 2·10⁻⁷ m (2000 Å), sheet resistance 10 Ω/cm²), is coated the above mentioned light-emitting composition by Spin Coater (Kyoei semiconductor K.K. IH-IIID) with a membrane thickness of 1.5.10⁻⁷ m (1500 Å) and dried at 60°C for 30 min. to form a light-emitting layer.

On the light-emitting layer so formed, gold is deposited as cathode layer A under vacuum of 0.67 Pa (5.0·10⁻⁶ Torr) with a depositing rate of 10⁻¹¹ m/s (0.1 Å/sec) in a film thickness of 2·10⁻⁹ m (20 Å). Then magnesium as cathode layer B is deposited on it to form a film with a thickness of 2·10⁻⁷ m (2000 Å).

### Measurement of EL element

By using the ITO side as the anode and the magnesium side as the cathode, a bias of 20 V is applied to the above element. A luminescence showing a luminance of 60 cd/m² is confirmed as the average value of five elements. For determination of luminance, Luminometer LS-110 manufactured by Minolta Camera Co., Ltd. is used.

### Example 18:

An El element is prepared in the same manner as in Example 17 except for using the above mentioned light-emitting material (5). The result is shown in Table 3.

### Example 19:

An El element is prepared in the same manner as in Example 17 except for using the above mentioned light-emitting material (6). The result is shown in Table 3.

### Comparative Example 9:

An element is prepared in the same manner as in Example 17 except that the cathode layer A is not provided. The result is shown in Table 4.

### Comparative Example 10:

An element is prepared in the same manner as in Example 18 except that the cathode layer A is not provided. The result is shown in Table 4.

### Comparative Example 11:

An element is prepared in the same manner as in Example 19 except that the cathode layer A is not provided. The result is shown in Table 4.

**Table 3**

| The figures in ( ) show membrane thickness (10⁻¹⁰ m = Å) | | | | | |
|---|---|---|---|---|---|
| Example | Material for the emitting layer | Material for the hole transport layer | Cathode layer A | Cathode layer B | Luminance* (cd/m²⁾ |
| 17 | 4 | IV | Au (20) | Mg (2000) | 60 |
| 18 | 5 | IV | Au (20) | Mg (2000) | 12 |
| 19 | 6 | IV | Au (20) | Mg (2000) | 3 |

| | | | | | |
|---|---|---|---|---|---|
| * When 20 V is applied | | | | | |

**Table 4**

| The figures in ( ) show membrane thickness (10⁻¹⁰ m = Å) | | | | | |
|---|---|---|---|---|---|
| Comparative Example | Material for the emitting layer | Material for the hole transport layer | Cathode layer A | Cathode layer B | Luminance* (cd/m²) |
| 7' | 4 | IV | none | Mg (2000) | 25 |
| 8 | 5 | IV | none | Mg (2000) | 0.7 |
| 9 | 6 | IV | none | Mg (2000) | 0.5 |

| | | | | | |
|---|---|---|---|---|---|
| * When 20 V is applied | | | | | |

## Claims

1. An organic electroluminescent element (1) in which an anode (13), a hole transport layer (15), a light-emitting layer (17) and a cathode (19) are laminated in this order, characterized in that said cathode comprises a metal block portion or portions (19A) comprising a metal A having a work function above 4.2 eV and a metal block portion or portions (19B) comprising a metal B having a work function at least 0.4 eV less than the work function of the metal A, both of the metal block portions of the metal A and of the metal B being in contact with the light-emitting layer (17).

2. An organic electroluminescent element according to Claim 1, wherein the difference between the work function of the metal A and the work function of the metal B is up to 2.5 eV.

3. An organic electroluminescent element according to Claim 2, wherein the difference is in the range of between 0.5 eV and 2.0 eV.

4. An organic electroluminescent element according to any one of Claims 1-3, wherein Ni, Au, Pt, Pd, Ag or Cu or an alloy thereof is used as the metal A.

5. An organic electroluminescent element according to Claim 4, wherein Ni, Au, Pt or Pd or an alloy thereof is used as the metal A.

6. An organic electroluminsecent element according to Claim 1, wherein Al, Mg, Li or In, or alloys thereof is used as the metal B.

7. An organic electroluminescent element according to any one of Claims 1-3, wherein the thickness of the thin film of metal A is 2·10⁻¹⁰ m to 2·10⁻⁸ m (2 Å to 200 Å).

8. An organic electroluminescent element according to Claim 7, wherein the thickness of the thin film of metal A is 5·10⁻¹⁰ m to 1.5·10⁻⁸ m (5 Å to 150 Å).

9. A process of the preparation of an organic electroluminescent element comprising an anode, a hole transport layer, a light-emitting layer and a cathode layer laminated in this order according to claim 1, characterized in that the cathode layer is formed on the light-emitting layer by firstly depositing by vacuum deposition a metal A having a work function above 4.2 eV to such a membrane thickness to form a discontinuous membrane of the metal A and subsequently depositing on the metal A by vacuum deposition a metal B having a work function at least 0.4 eV less than the work function of the metal A, whereby both of the deposited metals A and B are brought into contact with the light-emitting layer.

10. A process of the preparation of an organic electroluminescent element comprising an anode, a hole transport layer, a light-emitting layer and a cathode layer laminated in this order according to claim 1, characterized in that the cathode layer is formed on the light-emitting layer by firstly depositing by vacuum deposition a metal B to such a membrane thickness to form a discontinuous membrane of the metal B and subsequently depositing on the metal B by vacuum deposition a metal A having a work function above 4.2 eV and at least 0.4 eV above the work function of the metal B, whereby both of the deposited metals A and B are brought into contact with the light-emitting layer.

## Patentansprüche

1. Organisches Elektrolumineszenzelement (1), bei welchem eine Anode (13), eine Lochtransportschicht (15), eine lichtemittierende Schicht (17) und eine Kathode (19) in dieser Abfolge übereinander schichtweise angeordnet sind, dadurch gekennzeichnet, daß die Kathode einen Metallblockabschnitt oder -abschnitte (19A) aufweist, mit einem Metall A, das eine Austrittsarbeit über 4,2 eV aufweist, und einen Metallblockabschnitt oder -abschnittes (19B) mit einem Metall B, das eine Austrittsarbeit von zumindest 0,4 eV weniger als die Austrittsarbeit des Metalls A aufweist, wobei sowohl die Metallblockabschnitte aus dem Metall A wie dem Metall B sich in Kontakt mit der lichtemittierenden Schicht (17) befinden.

2. Organisches Elektrolumineszenzelement nach Anspruch 1, wobei die Differenz zwischen der Austrittsarbeit des Metalls A und der Austrittsarbeit des Metalls B bis hin zu 2, 5 eV beträgt.

3. Organisches Elektrolumineszenzelement nach Anspruch 2, wobei die Differenz im Bereich zwischen 0,5 eV und 2,0 eV liegt.

4. Organisches Elektrolumineszenzelement nach einem der Ansprüche 1 bis 3, wobei Ni, Au, Pt, Pd, Ag oder Cu oder eine Legierung aus diesen als das Metall A verwendet sind.

5. Organisches Elektrolumineszenzelement nach Anspruch 4, wobei Ni, Au, Pt oder Pd oder eine Legierung aus diesen als das Metall A verwendet sind.

6. Organisches Elektrolumineszenzelement nach Anspruch 1, wobei Al, Mg, Li oder In oder Legierungen daraus als das Metall B verwendet sind.

7. Organisches Elektrolumineszenzelement nach einem der Ansprüche 1 bis 3, wobei die Dicke der Dünnschicht aus dem Metall A 2 x 10⁻¹⁰ m bis 2 x 10⁻⁸ m (2 Å bis 200 Å) beträgt.

8. Organisches Elektrolumineszenzelement nach Anspruch 7, wobei die Dicke der Dünnschicht aus dem Metall A 5 x 10⁻¹⁰ m bis 1,5 x 10⁻⁸ m (5 Å bis 150 Å) beträgt.

9. Verfahren zur Fertigung eines organischen Elektrolumineszenzelements mit einer Anode, einer Lochtransportschicht, einer lichtemittierenden Schicht und einer Kathodenschicht, die in dieser Abfolge übereinander schichtweise angeordnet sind, nach Anspruch 1, dadurch gekennzeichnet, daß die Kathodenschicht auf einer lichtemittierenden Schicht gebildet wird, indem zunächst durch Vakuumabscheiden ein Metall A mit einer Austrittsarbeit über 4,2 eV auf eine derartige Membrandicke abgeschieden wird, daß eine diskontinuierliche Membran aus dem Metall A gebildet ist, woraufhin auf dem Metall A durch Vakuumabscheiden ein Metall B mit einer Austrittsarbeit von zumindest 0,4 eV weniger als die Austrittsarbeit des Metalls A abgeschieden wird, wobei beide abgeschiedenen Metalle A und B in Kontakt mit der lichtemittierenden Schicht gebracht sind.

10. Verfahren zur Fertigung eines organischen Elektrolumineszenzelements mit einer Anode, einer Lochtransportschicht, einer lichtemittierenden Schicht und einer Kathodenschicht, die in dieser Abfolge übereinander schichtweise angeordnet sind, nach Anspruch 1, dadurch gekennzeichnet, daß die Kathodenschicht auf einer lichtemittierenden Schicht gebildet wird, indem zunächst durch Vakuumabscheiden eines Metalls B auf eine derartige Membrandicke abgeschieden wird, daß eine diskontinuierliche Membran aus dem Metall B gebildet ist, woraufhin auf dem Metall B durch Vakuumabscheiden eines Metalls A mit einer Austrittsarbeit über 4,2 eV sowie zumindest 0,4 eV über der Austrittsarbeit des Metalls B abgeschieden wird, wodurch beide abgeschiedenen Metalle A und B in Kontakt mit der lichtemittierenden Schicht gebracht sind.

## Revendications

1. Élément organique électroluminescent (1) dans lequel une anode (13), une couche de transport de trous (15), une couche émettrice de lumière (17) et une cathode (19) sont stratifiés suivant cet ordre, caractérisé en ce que ladite cathode comprend une partie constituée par un bloc métallique ou des parties (19A) comprenant un métal A ayant un travail d'extraction supérieur à 4,2 eV, et une partie constituée par un un bloc métallique ou des parties (19B) comprenant un métal B ayant un travail d'extraction inférieur d'au moins 0,4 eV à celui du métal A, les deux parties contsituées des blocs métalliques du métal A et du métal B étant en contact avec la couche émettrice de lumière (17).

2. Elément organique électroluminescent selon la revendication 1, où la différence entre le travail d'extraction du métal A et le travail d'extraction du métal B est supérieure à 2,5 eV.

3. Élément organique électroluminescent selon la revendication 2, où la différence se situe dans le domaine compris entre 0,5 eV et 2,0 eV.

4. Élément organique électroluminescent selon l'une quelconque des revendications 1 à 3, où Ni, Au, Pt, Pd, Ag ou Cu, ou un de leurs alliages, sont utilisés en tant que métal A.

5. Élément organique électroluminescent selon la revendication 4, où Ni, Au, Pt ou Pd ou un de leurs alliages sont utilisés en tant que métal B.

6. Élément organique électroluminescent selon la revendication 1, où Al, Mg, Li ou In, ou leurs alliages, sont utilisés en tant que métal B.

7. Élément organique électroluminescent selon l'une quelconque des revendications 1 à 3, où l'épaisseur du film mince de métal A est de 2.10⁻¹⁰ m à 2.10⁻⁸ m (2 Å to 200 Å).

8. Élément organique électroluminescent selon la revendication 7, où l'épaisseur du film mince de métal A est de 5.10⁻¹⁰ m à 1,5.10⁻¹⁰ m (5 Å à 150 Å)

9. Procédé de préparation d'un élément organique électroluminescent comprenant une anode, une couche de transport de trous, une couche émettrice de lumière et une couche cathodique stratifiée suivant cet ordre selon la revendication 1, caractérisé en ce que la couche cathodique est formée sur la couche émettrice de lumière, d'abord par dépôt sous vide d'un métal A ayant un travail d'extraction supérieur à 4,2 eV jusqu'à une épaisseur de membrane telle qu'il se forme une membrane discontinue du métal A, et par la suite, par dépôt sous vide sur le métal A, d'un métal B ayant un travail d'extraction inférieur d'au moins 0,4 eV au travail d'extraction du métal A, ce faisant, les deux métaux déposés A et B sont mis en contact avec la couche émettrice de lumière.

10. Procédé de préparation d'un élément organique électroluminescent comprenant une anode, une couche de transport de trous, une couche émettrice de lumière et une couche cathodique stratifiée suivant cet ordre selon la revendication 1, caractérisé en ce que la couche cathodique est formée sur la couche émettrice de lumière, d'abord par dépôt sous vide d'un métal B jusqu'à une épaisseur de membrane telle qu'il se forme une membrane discontinue du métal B et par la suite, par dépôt sous vide sur le métal B, d'un métal A ayant un travail d'extraction supérieur à 4,2 eV et supérieur d'au moins 0,4 eV au travail d'extraction du métal B, ce faisant, les deux métaux A et B sont mis en contact avec la couche émettrice de lumière.
